# EUROPEAN PATENT APPLICATION

(11) **EP 4 749 308 A1**
(43) Date of publication of application: **27.05.2026**
(21) Application number: 24856798.4
(22) Date of filing: 20.08.2024
(51) Int. Cl.: G01R 31/396, G01R 31/385, G01R 31/382, G01R 31/36, G01R 19/12, G01R 19/30, G01R 31/392, H01M 10/0525

(54) **APPARATUS AND METHOD FOR MANAGING BATTERY**

(30) Priority: 21.08.2023 KR 20230109374
(71) Applicant: LG Energy Solution, Ltd., Seoul 07335 (KR)
(72) Inventor: KANG, Hye-Jin, Daejeon 34122 (KR); JEONG, Hee-Seok, Daejeon 34122 (KR); BAE, Yoon-Jung, Daejeon 34122 (KR)
(74) Representative: Goddar, Heinz J.
(86) International application number: PCT/KR2024/012380
(87) International publication number: WO 2025/042187

(57) **Abstract**

A battery management apparatus according to an embodiment of the present disclosure includes a voltage obtaining unit configured to obtain an open circuit voltage of the battery; a profile obtaining unit configured to obtain a differential profile representing a corresponding relationship between a differential capacity and a voltage of a battery; and a control unit configured to determine a voltage pattern of the battery based on the open circuit voltage and pre-stored voltage history, determine a plurality of peaks in the differential profile when the determined voltage pattern is a predetermined pattern, determine a negative electrode peak and a positive electrode peak among the determined plurality of peaks, and diagnose a state of the battery by comparing a change rate of the negative electrode peak with respect to a preset reference negative electrode peak and a change rate of the positive electrode peak with respect to a preset reference positive electrode peak.

## Description

### TECHNICAL FIELD

This application is based on and claims priority from Korean Patent Application No. 10-2023-0109374, filed on August 21, 2023, with the Korean Intellectual Property Office, the disclosure of which is incorporated herein in its entirety by reference.

The present disclosure relates to a battery management apparatus and method, and more particularly, to a battery management apparatus and method for diagnosing a state of a battery and adjusting a use condition of the battery according to the diagnosis result.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density. Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing a battery management apparatus and method capable of tracking and diagnosing a state of a battery to increase the lifespan of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a profile obtaining unit configured to obtain a differential profile representing a corresponding relationship between a differential capacity and a voltage of a battery; a voltage obtaining unit configured to obtain an open circuit voltage of the battery; and a control unit configured to determine a voltage pattern of the battery based on the open circuit voltage and pre-stored voltage history, determine a plurality of peaks in the differential profile when the determined voltage pattern is a predetermined pattern, determine a negative electrode peak and a positive electrode peak among the determined plurality of peaks, and diagnose a state of the battery by comparing a change rate of the negative electrode peak with respect to a preset reference negative electrode peak and a change rate of the positive electrode peak with respect to a preset reference positive electrode peak.

The control unit may be configured to calculate a differential capacity change rate of the negative electrode peak, calculate a differential capacity change rate of the positive electrode peak, compare the differential capacity change rate of the negative electrode peak and the differential capacity change rate of the positive electrode peak, and diagnose the state of the battery based on the comparison result.

The control unit may be configured to calculate the differential capacity change rate of the negative electrode peak by calculating a ratio of the differential capacity of the negative electrode peak to a preset reference negative electrode differential capacity, and calculate the differential capacity change rate of the positive electrode peak by calculating a ratio of the differential capacity of the positive electrode peak to a preset reference positive electrode differential capacity.

The control unit may be configured to diagnose the state of the battery as a positive and negative electrode deterioration state when the differential capacity change rate of the negative electrode peak exceeds the differential capacity change rate of the positive electrode peak.

The control unit may be configured to diagnose the state of the battery as a positive electrode deterioration state when the differential capacity change rate of the negative electrode peak is less than or equal to the differential capacity change rate of the positive electrode peak.

The control unit may be configured to adjust a use condition preset for the battery based on the diagnosed state of the battery.

The control unit may be configured to calculate a voltage change rate based on the open circuit voltage and the pre-stored voltage history, and compare the calculated voltage change rate with a preset reference change rate to determine the voltage pattern of the battery as a decrease pattern or a non-decrease pattern.

The control unit may be configured to determine the plurality of peaks in the differential profile when the determined voltage pattern is the decrease pattern.

The voltage obtaining unit may be configured to obtain an open circuit voltage after charging of the battery is terminated.

The profile obtaining unit may be configured to obtain a differential profile representing a corresponding relationship between the differential capacity and the voltage of the battery during a charging process.

A battery pack according to another aspect of the present disclosure may comprise the battery management apparatus according to an aspect of the present disclosure.

A vehicle according to another aspect of the present disclosure may comprise the battery management apparatus according to an aspect of the present disclosure.

A battery management method according to still another aspect of the present disclosure may comprise: a voltage pattern determining step of determining a voltage pattern of a battery based on an open circuit voltage of the battery and pre-stored voltage history; a peak determining step of determining a plurality of peaks in a differential profile representing a corresponding relationship between a differential capacity and a voltage of the battery when the determined voltage pattern is a predetermined pattern; an electrode peak determining step of determining a negative electrode peak and a positive electrode peak among the determined plurality of peaks; and a state diagnosing step of diagnosing a state of the battery by comparing a change rate of the negative electrode peak with respect to a preset reference negative electrode peak and a change rate of the positive electrode peak with respect to a preset reference positive electrode peak.

### Advantageous Effects

According to one aspect of the present disclosure, the deterioration of the battery and the cause of the battery deterioration may be specifically diagnosed. In particular, since composite deterioration in which both the positive electrode and the negative electrode are deteriorated may also be diagnosed as the cause of the battery deterioration, there is an advantage in that a more accurate diagnosis of the current state of the battery is possible.

In addition, according to one aspect of the present disclosure, since the use condition of the battery is appropriately adjusted according to the state of the battery, the life of the battery may be increased.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a drawing schematically showing a differential profile according to an embodiment of the present disclosure.
FIG. 3 is a drawing schematically showing a reference profile according to an embodiment of the present disclosure.
FIG. 4 is a drawing schematically showing a differential capacity of a plurality of peaks included in the reference profile and the differential profile according to an embodiment of the present disclosure.
FIG. 5 is a diagram schematically showing an exemplary configuration of a battery pack according to another embodiment of the present disclosure.
FIG. 6 is a diagram schematically showing a vehicle according to still another embodiment of the present disclosure.
FIG. 7 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Here, a battery means a physically separable independent cell including a negative electrode terminal and a positive electrode terminal. For example, a lithium-ion battery or a lithium polymer battery may be considered a battery. In addition, a battery may mean a battery bank, a battery module, or a battery pack in which a plurality of cells are connected in series and/or in parallel. Hereinafter, for convenience of explanation, a battery is described as meaning a single independent cell.

Hereinafter, preferred embodiments of the present disclosure will be described in detail with reference to the accompanying drawings.

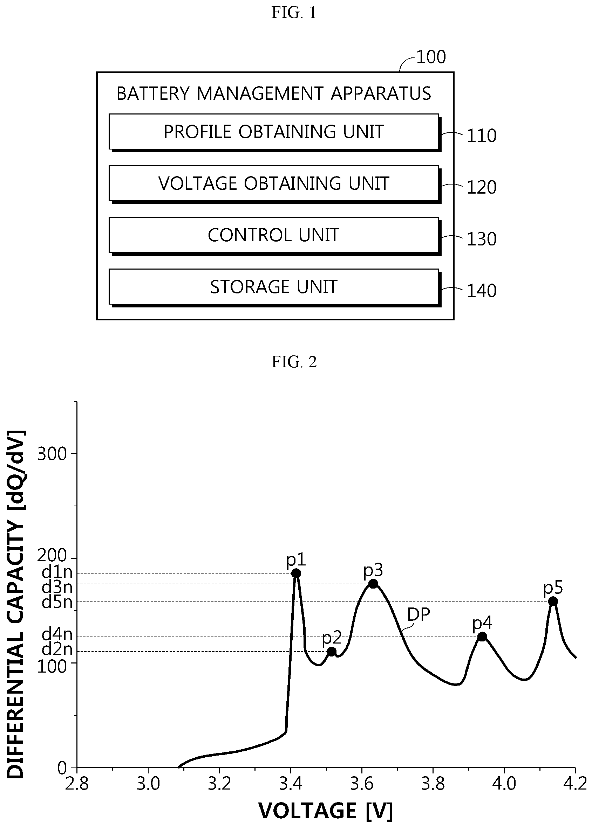

FIG. 1 is a diagram schematically showing a battery management apparatus 100 according to an embodiment of the present disclosure.

Referring to FIG. 1, the battery management apparatus 100 according to an embodiment of the present disclosure may include a profile obtaining unit 110, a voltage obtaining unit 120, and a control unit 130.

The profile obtaining unit 110 may be configured to obtain a differential profile DP representing a corresponding relationship between the differential capacity and voltage of the battery.

Here, the differential capacity represents the instantaneous change rate of the capacity with respect to the voltage. That is, the differential capacity may be expressed as 'dQ/dV' as a value obtained by differentiating the capacity with respect to the voltage.

The battery profile is a profile representing the corresponding relationship between voltage (V) and capacity (Q) when the SOC of the battery is charged from 0% to 100%. Also, when the battery profile is differentiated with respect to voltage, a differential profile DP representing the corresponding relationship between differential capacity (dQ/dV) and voltage (V) may be generated. Conversely, the battery profile may also represent the corresponding relationship between voltage (V) and capacity (Q) when the SOC of the battery is discharged from 100% to 0%.

For example, there is no special limitation on the C-rate in charge or discharge for generating a battery profile. However, preferably, the battery should be charged or discharged at a low rate to obtain a more accurate battery profile and differential profile DP. For example, a battery profile may be generated in the process of charging or discharging a battery at 0.05 C.

Preferably, the profile obtaining unit 110 may be configured to obtain a differential profile DP representing a corresponding relationship between the differential capacity and voltage of the battery during a charging process. For example, a battery profile may be obtained during a process in which the battery is charged, and a differential profile DP may be obtained from the battery profile.

For example, the profile obtaining unit 110 may directly receive the differential profile DP of the battery from the outside. That is, the profile obtaining unit 110 may obtain the differential profile DP by being connected to the outside by wire and/or wirelessly and receiving the differential profile DP.

As another example, the profile obtaining unit 110 may receive battery information about the voltage and capacity of the battery. Also, the profile obtaining unit 110 may generate a battery profile based on the received battery information, and generate a differential profile DP based on the generated battery profile. That is, the profile obtaining unit 110 may obtain a differential profile DP by directly generating a differential profile DP based on the battery information.

As still another example, the profile obtaining unit 110 may directly measure the voltage and current of the battery. For example, the profile obtaining unit 110 may be directly connected to the positive electrode terminal and the negative electrode terminal of the battery to directly measure the voltage of the battery. In addition, the profile obtaining unit 110 may measure the charge and discharge current amount of the battery, and calculate the capacity of the battery based on the measured current amount. In addition, the profile obtaining unit 110 may generate a differential profile DP based on the voltage and capacity of the battery. That is, the profile obtaining unit 110 may obtain a differential profile DP based on the directly measured voltage and current of the battery.

The profile obtaining unit 110 may be connected to communicate with the control unit 130. For example, the profile obtaining unit 110 may be connected to the control unit 130 by wire and/or wirelessly. The profile obtaining unit may transmit the obtained differential profile DP to the control unit 130.

FIG. 2 is a drawing schematically showing a differential profile DP according to an embodiment of the present disclosure.

In the embodiment of FIG. 2, the differential profile DP may be represented as a two-dimensional graph in which the X-axis is set to voltage (V) and the Y-axis is set to differential capacity (dQ/dV).

The voltage obtaining unit 120 may be configured to obtain the open circuit voltage (OCV) of the battery.

Here, the open circuit voltage refers to the voltage of the battery measured when the battery is in the rest state.

Specifically, the voltage obtaining unit 120 may be configured to obtain an open circuit voltage after charging of the battery is terminated. For example, when the voltage of the battery reaches the charge end voltage (e.g., 4.2 V), charging of the battery may be terminated. After charging of the battery is terminated and a certain period of time has passed, the battery may be stabilized while its voltage becomes lower than the charge end voltage. The voltage obtaining unit 120 may obtain the open circuit voltage of the stabilized battery.

For example, the voltage obtaining unit 120 may directly receive the open circuit voltage of the battery from the outside. That is, the voltage obtaining unit 120 may obtain the open circuit voltage of the battery by being connected to the outside by wire and/or wirelessly and receiving the open circuit voltage.

As another example, the voltage obtaining unit 120 may be directly connected to the positive electrode terminal and the negative electrode terminal of the battery. Then, the voltage obtaining unit 120 may obtain the open circuit voltage by directly measuring the open circuit voltage of the stabilized battery. In some cases, the voltage obtaining unit 120 may be implemented as a component that measures the voltage of the battery in the profile obtaining unit 110.

The voltage obtaining unit 120 may be connected to communicate with the control unit 130. For example, the voltage obtaining unit 120 may be connected to the control unit 130 by wire and/or wirelessly. The voltage obtaining unit may transmit the obtained open circuit voltage to the control unit 130.

The control unit 130 may be configured to determine the voltage pattern of the battery based on the open circuit voltage and pre-stored voltage history.

Here, the voltage history may be information in which the open circuit voltage and the measurement time point are mapped. That is, the voltage history may be history information about the open circuit voltage measured at the previous time point. For example, if the battery has been charged n times, n open circuit voltages measured after the end of the charge may be stored as the voltage history.

The control unit 130 may compare the measured open circuit voltage with one or more open circuit voltages included in the voltage history. Specifically, the control unit 130 may determine a change pattern of the open circuit voltage over time.

For example, if the open circuit voltage decreases over time, the control unit 130 may determine the voltage pattern as a decrease pattern. As another example, if the open circuit voltage increases over time or the open circuit voltage remains the same over time, the control unit 130 may determine the voltage pattern as a non-decrease pattern. That is, the non-decrease pattern may include a voltage increase pattern and a voltage maintenance pattern.

The control unit 130 may be configured to determine a plurality of peaks in the differential profile DP when the determined voltage pattern is a predetermined pattern.

Here, the voltage pattern determined by the control unit 130 is a decrease pattern or a non-decrease pattern. The control unit 130 may be configured to determine a plurality of peaks in the differential profile DP when the determined voltage pattern is a decrease pattern. Conversely, the control unit 130 may not determine a plurality of peaks in the differential profile DP when the determined voltage pattern is a non-decrease pattern.

Specifically, the control unit 130 may determine a point in the differential profile DP where the slope (instantaneous change rate) is 0 and the shape is convex upward as a peak. That is, the slope on the low voltage side centered on the peak is positive, and the slope on the high voltage side is negative. In other words, the control unit 130 may be configured to determine the maximum point of the differential profile DP as a peak.

For example, in the embodiment of FIG. 2, the control unit 130 may determine the first peak p1, the second peak p2, the third peak p3, the fourth peak p4, and the fifth peak p5 in the differential profile DP.

The control unit 130 may be configured to determine a negative electrode peak and a positive electrode peak among the determined plurality of peaks.

Here, the negative electrode peak is the peak that best represents the state of the negative electrode, and the positive electrode peak is the peak that best represents the state of the positive electrode. In general, the negative electrode peak appears in a low voltage range (e.g., a voltage range corresponding to a SOC (State of Charge) section of 50% or below), and the positive electrode peak appears in a high voltage range (e.g., a voltage range corresponding to a SOC section exceeding 50%).

The negative electrode peak may be determined based on the type of the negative electrode of the battery. For example, if the battery includes a single negative electrode active material, a negative electrode voltage range at which the negative electrode peak appears may be preset according to the type of the negative electrode active material. As another example, if the battery includes a plurality of negative electrode active materials, a negative electrode voltage range at which the negative electrode peak appears may be preset according to the types of the plurality of negative electrode active materials and the ratio of the plurality of negative electrode active materials. The control unit 130 may determine the negative electrode peak among the plurality of peaks included in the differential profile DP based on the preset negative electrode voltage range so as to correspond to the type of the negative electrode of the battery.

For example, in the embodiment of FIG. 2, the battery is a graphite-based battery including graphite as a negative electrode active material. The control unit 130 may determine the first peak p1 as the negative electrode peak among the first peak p1, the second peak p2, the third peak p3, the fourth peak p4, and the fifth peak p5 based on a negative electrode voltage range preset for the graphite-based battery.

The positive electrode peak may be determined based on the type of the positive electrode of the battery. The voltage range at which the positive electrode peak appears may be preset based on the types of the plurality of positive electrode active materials and the ratio of the plurality of positive electrode active materials. For example, the positive electrode voltage range at which the positive electrode peak appears may be set differently for a battery having a ratio of NCM (Ni:Co:Mn) of 8:1:1 and a battery having a ratio of 6:2:2. The control unit 130 may determine the positive electrode peak among the plurality of peaks included in the differential profile DP based on the preset positive electrode voltage range so as to correspond to the type of the positive electrode of the battery. For example, in the embodiment of FIG. 2, the battery is a high nickel-based battery having a ratio of NCM of 8:1:1. The control unit 130 may determine the fifth peak p5 among the first peak p1, the second peak p2, the third peak p3, the fourth peak p4, and the fifth peak p5 as the positive electrode peak based on the positive electrode voltage range preset for the high nickel-based battery.

The control unit 130 may be configured to diagnose the state of the battery by comparing a change rate of the negative electrode peak with respect to a preset reference negative electrode peak and a change rate of the positive electrode peak with respect to a preset reference positive electrode peak.

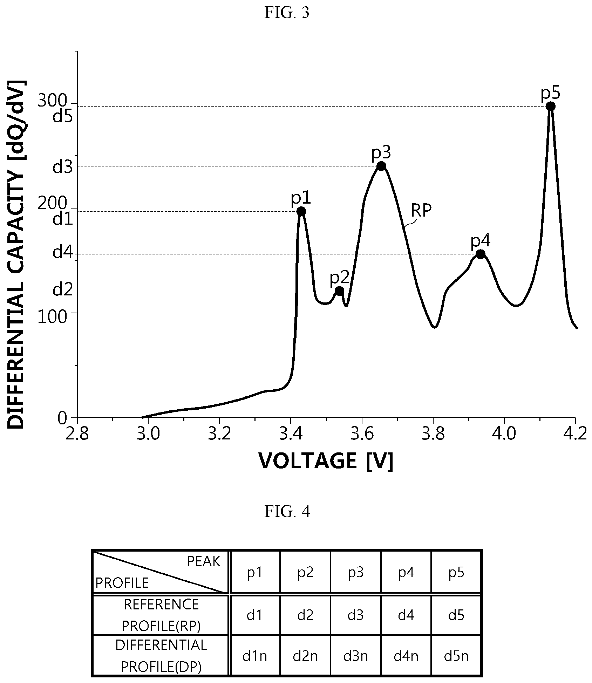

FIG. 3 is a drawing schematically showing a reference profile RP according to an embodiment of the present disclosure. Specifically, the reference profile RP of FIG. 3 is a differential profile for a battery in the BOL (Beginning of life) state. The reference profile RP may include a first peak p1, a second peak p2, a third peak p3, a fourth peak p4, and a fifth peak p5. Here, the first peak p1 may be preset as a reference negative electrode peak, and the fifth peak p5 may be preset as a reference positive electrode peak. In addition, the differential capacity of the reference negative electrode peak may be preset as the reference negative electrode differential capacity. Similarly, the differential capacity of the reference positive electrode peak may be preset as the reference positive electrode differential capacity.

Specifically, the control unit 130 may calculate the differential capacity change rate of the negative electrode peak based on the differential capacity of the negative electrode peak. For example, the control unit 130 may calculate the differential capacity change rate of the negative electrode peak by calculating the ratio of the differential capacity of the negative electrode peak to the preset reference negative electrode differential capacity. For example, the control unit 130 may calculate the differential capacity change rate of the negative electrode peak by calculating the formula "differential capacity of negative electrode peak ÷ reference negative electrode differential capacity × 100". Also, in the formula, 100 is a constant for representing the differential capacity change rate in the range of 0% to 100%, and thus can be omitted. If this constant is omitted, the differential capacity change rate may have a value in the range of 0 to 1.

Similarly, the control unit 130 may calculate the differential capacity change rate of the positive electrode peak based on the differential capacity of the positive electrode peak. For example, the control unit 130 may calculate the differential capacity change rate of the positive electrode peak by calculating the ratio of the differential capacity of the positive electrode peak to the preset reference positive electrode differential capacity. For example, the control unit 130 may calculate the differential capacity change rate of the positive electrode peak by calculating the formula "differential capacity of positive electrode peak ÷ reference positive electrode differential capacity × 100". In the formula here, the constant may also be omitted.

FIG. 4 is a drawing schematically showing a differential capacity of a plurality of peaks included in the reference profile RP and the differential profile DP according to an embodiment of the present disclosure.

In the embodiment of FIG. 4, the reference negative electrode differential capacity is d1, and the reference positive electrode differential capacity is d5. In addition, the differential capacity of the negative electrode peak included in the differential profile DP is d1n, and the differential capacity of the positive electrode peak is d5n. The control unit 130 may calculate the differential capacity change rate of the negative electrode peak by calculating the formula "d1n ÷ d1 × 100". In addition, the control unit 130 may calculate the differential capacity change rate of the positive electrode peak by calculating the formula "d5n ÷ d5 × 100".

In addition, the control unit 130 may be configured to compare the differential capacity change rate of the negative electrode peak with the differential capacity change rate of the positive electrode peak. Specifically, the control unit 130 may compare the magnitude of the differential capacity change rate of the negative electrode peak with the differential capacity change rate of the positive electrode peak. For example, the control unit 130 may compare the magnitude of the differential capacity change rate of the negative electrode peak with the differential capacity change rate of the positive electrode peak.

The control unit 130 may be configured to diagnose the state of the battery based on the comparison result.

For example, the control unit 130 may be configured to diagnose the state of the battery as a positive and negative electrode deterioration state if the differential capacity change rate of the negative electrode peak exceeds the differential capacity change rate of the positive electrode peak. Conversely, the control unit 130 may be configured to diagnose the state of the battery as a positive electrode deterioration state if the differential capacity change rate of the negative electrode peak is less than or equal to the differential capacity change rate of the positive electrode peak.

Specifically, if the positive electrode of the battery is in a deteriorated state, the voltage pattern of the open circuit voltage after the charge end of the battery may appear as a decrease pattern. In addition, if the negative electrode of the battery is in a deteriorated state, the differential capacity change rate of the negative electrode peak of the battery may exceed the differential capacity change rate of the positive electrode peak. That is, the battery management apparatus 100 may diagnose whether there is complex deterioration of the positive electrode and the negative electrode by considering the voltage pattern of the open circuit voltage of the battery and the differential capacity change rates of the positive and negative electrode peaks together. Therefore, according to the battery management apparatus 100, not only whether there is deterioration of the battery, but also the cause of the deterioration of the battery may be specifically diagnosed. In particular, since complex deterioration in which both the positive electrode and the negative electrode are deteriorated may be diagnosed as the cause of the deterioration of the battery, the battery management apparatus 100 has an advantage in that it may diagnose the current state of the battery more accurately.

Meanwhile, the control unit 130 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 130 may be implemented as a set of program modules. At this time, the program module may be stored in a memory and executed by the control unit 130. The memory may be located inside or out of the control unit 130 and may be connected to the control unit 130 by various well-known means.

In addition, the battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Specifically, the storage unit 140 may store information necessary for the control unit 130 to diagnose the state of the battery. For example, the storage unit 140 may store the open circuit voltage of the battery, the voltage history, the differential profile DP and the reference profile RP of the battery, etc. In addition, the control unit 130 may access the storage unit 140 to obtain information necessary for diagnosing the state of the battery.

Below, a specific embodiment in which the control unit 130 determines a voltage pattern is described.

The control unit 130 may be configured to calculate a voltage change rate based on the open circuit voltage and the pre-stored voltage history. The control unit 130 may determine a voltage pattern for the measured open circuit voltage (hereinafter, referred to as the first open circuit voltage) and one or more open circuit voltages stored in the voltage history (hereinafter, referred to as the second open circuit voltage).

For example, the control unit 130 may analyze the pattern of the open circuit voltage over time through regression analysis on the first open circuit voltage and the second open circuit voltage. As a result of the regression analysis, a regression model between time (or cycle) and the open circuit voltage may be derived. Here, the regression model may represent the change rate of the open circuit voltage over time. For example, if y is the open circuit voltage and x is time, the regression model may be a linear regression model expressed by the linear equation of "y = ax + b". As another example, the regression model may be a nonlinear regression model expressed by a nonlinear equation. The control unit 130 may calculate the voltage change rate (the change rate of the open circuit voltage over time) from the regression model.

In addition, the control unit 130 may be configured to compare the calculated voltage change rate with a preset reference change rate to determine the voltage pattern of the battery as a decrease pattern or a non-decrease pattern.

Furthermore, the open circuit voltage of the battery may be included in the voltage history and used to determine the voltage pattern for the open circuit voltage at the next time point.

The battery management apparatus 100 may determine the voltage pattern of the open circuit voltage measured at the current time point and the past history of the open circuit voltage of the battery by using a statistical technique. That is, not only the open circuit voltage at a specific time point is considered, but the voltage pattern of the open circuit voltage of the entire life cycle of the battery is used to diagnose the state of the battery. Therefore, the battery management apparatus 100 has the advantage of being able to track and diagnose the state of the battery.

Meanwhile, the control unit 130 may also determine the negative electrode peak and the positive electrode peak based on the peak included in the reference profile RP and the peak included in the differential profile DP.

The control unit 130 may compare the differential capacity of a peak included in the negative electrode voltage band of the reference profile RP and a peak included in the negative electrode voltage band of the differential profile DP. Then, the peak with the largest difference in differential capacity may be determined as the negative electrode peak.

For example, referring to FIGS. 2 to 4, it is assumed that the first peak p1 and the second peak p2 of the differential profile DP are included in the negative electrode voltage range of the differential profile DP, and the first peak p1 and the second peak p2 of the reference profile RP are included in the negative electrode voltage range of the reference profile RP. The control unit 130 may calculate the first differential capacity difference (|d1 - d1n|) between the first peaks p1 and the second differential capacity difference (|d2 - d2n|) between the second peaks p2. Then, the control unit 130 may determine the first peak p1 as the negative electrode peak if the first differential capacity difference is greater than or equal to the second differential capacity difference. Conversely, the control unit 130 may determine the second peak p2 as the negative electrode peak if the first differential capacity difference is less than the second differential capacity difference.

The control unit 130 may compare the differential capacity of a peak included in the positive electrode voltage band of the reference profile RP and a peak included in the positive electrode voltage band of the differential profile DP. Then, the peak with the largest difference in differential capacity may be determined as the positive electrode peak.

For example, referring to FIGS. 2 to 4, it is assumed that the third peak p3, the fourth peak p4, and the fifth peak p5 of the differential profile DP are included in the positive electrode voltage band of the differential profile DP, and the third peak p3, the fourth peak p4, and the fifth peak p5 of the reference profile RP are included in the positive electrode voltage band of the reference profile RP. The control unit 130 may calculate the third differential capacity difference (|d3 - d3n|) between the third peak p3s, the fourth differential capacity difference (|d4 - d4n|) between the fourth peak p4s, and the fifth differential capacity difference (|d5 - d5n|) between the fifth peak p5s. In addition, the control unit 130 may determine the peak having the largest differential capacity difference among the third peak p3, the fourth peak p4, and the fifth peak p5 as the positive electrode peak. For example, if the fifth differential capacity difference is greater than the third differential capacity difference and the fourth differential capacity difference, the fifth peak p5 may be determined as the positive electrode peak. If there are multiple peaks with the largest differential capacity difference, the peak on the high voltage side among those peaks may be determined as the positive electrode peak.

The control unit 130 may be configured to adjust a preset use condition for the battery based on the diagnosed state of the battery.

As described above, the state of the battery may be diagnosed as a positive electrode deterioration state or a positive and negative electrode deterioration state. In response to the diagnosis result, the control unit 130 may adjust the use condition of the battery.

For example, the use condition set for the battery may include the charge end voltage, the discharge end voltage, the upper limit temperature, and the upper limit of the charge and discharge C-rate. If the use condition is adjusted according to the state of the battery, the degradation of the battery may be delayed. This is because the battery may be deviated from a vulnerable deterioration environment (or deterioration cause) as the use condition changes.

For example, if the state of battery is diagnosed as the positive electrode deterioration state, the control unit 130 may prevent a reaction from occurring on the positive electrode high potential side by reducing the charge end voltage. In addition, the control unit 130 may prevent the reaction of the battery from occurring too actively by reducing the upper limit temperature. In other words, if the state of battery is diagnosed as the positive electrode deterioration state, the control unit 130 may prevent further deterioration of the positive electrode by reducing the charge end voltage and/or the upper limit temperature.

As another example, if the state of the battery is diagnosed as a positive and negative electrode deterioration state, the control unit 130 may prevent rapid charging from proceeding by reducing the upper limit of the charge and discharge C-rate. Meanwhile, the positive and negative electrode deterioration state means a state in which both the positive electrode and the negative electrode are deteriorated. Therefore, the control unit 130 may also reduce the charge end voltage and/or the upper limit temperature, similarly to the case in which the state of the battery is diagnosed as a positive electrode deterioration state.

The battery management apparatus has the advantage of being able to prevent further deterioration of the battery by appropriately adjusting the use condition to correspond to the state of battery. In other words, the lifespan of the battery may be extended by adjusting the use condition of the battery management apparatus.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the voltage obtaining unit 120, the profile obtaining unit 110, the control unit 130 and the storage unit 140 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

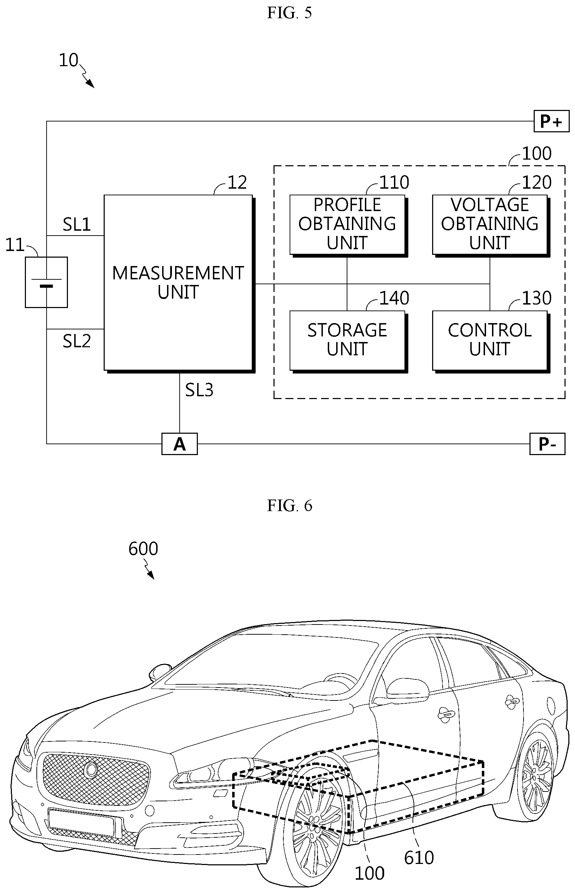

FIG. 5 is a diagram showing an exemplary configuration of a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

A measurement unit 12 may be connected to a first sensing line SL1, a second sensing line SL2, and a third sensing line SL3. Specifically, the measurement unit 12 may be connected to a positive electrode terminal of the battery 11 through the first sensing line SL1, and may be connected to a negative electrode terminal of the battery 11 through the second sensing line SL2. The measurement unit 12 may measure the voltage of the battery 11 based on the voltage measured at each of the first sensing line SL1 and the second sensing line SL2.

In addition, the measurement unit 12 may be connected to an ampere meter A through the third sensing line SL3. For example, the ampere meter A may be an ammeter or a shunt resistor capable of measuring the charging current and the discharging current of the battery 11. The measurement unit 12 may calculate the charge amount by measuring the charging current of the battery 11 through the third sensing line SL3. Also, the measurement unit 12 may calculate the discharge amount by measuring the discharge current of the battery 11 through the third sensing line SL3.

One end of the load may be connected to the positive electrode terminal P+ of the battery pack 10, and the other end may be connected to the negative electrode terminal P- of the battery pack 10. Accordingly, the positive electrode terminal of the battery 11, the positive electrode terminal P+ of the battery pack 10, the load 2, the negative electrode terminal P- of the battery pack 10, and the negative electrode terminal of the battery 11 may be electrically connected.

For example, the load may be a charge and discharge device, or a motor of an electric vehicle powered by the battery 11.

FIG. 6 is a diagram schematically showing a vehicle 600 according to still another embodiment of the present disclosure.

Referring to FIG. 6, the battery pack 610 according to an embodiment of the present disclosure may be included in a vehicle 600 such as an electric vehicle (EV) or a hybrid vehicle (HV). Here, the battery pack 10 described above may be applied as the battery pack 610. Additionally, the battery pack 610 may drive the vehicle 600 by supplying power to the motor through an inverter provided in the vehicle 600. Here, the battery pack 610 may include the battery management apparatus 100.

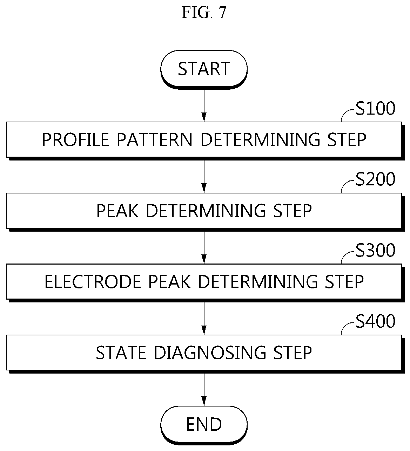

FIG. 7 is a diagram schematically showing a battery management method according to still another embodiment of the present disclosure.

Preferably, each step of the battery management method may be performed by the battery management apparatus 100. Hereinafter, for convenience of explanation, contents overlapping with the previously described contents will be omitted or briefly described.

The voltage pattern determining step (S100) is a step of determining a voltage pattern of a battery based on an open circuit voltage and pre-stored voltage history of the battery, and may be performed by the control unit 130.

For example, the control unit 130 may compare the measured open circuit voltage with one or more open circuit voltages included in the voltage history. Specifically, the control unit 130 may determine a change pattern of the open circuit voltage over time. Here, the voltage pattern may be determined as a decrease pattern or a non-decrease pattern.

The peak determining step (S200) is a step of determining a plurality of peaks in a differential profile DP representing a corresponding relationship between the differential capacity and voltage of the battery when the determined voltage pattern is a predetermined pattern, and may be performed by the control unit 130.

Preferably, the control unit 130 may be configured to determine a plurality of peaks in the differential profile DP when the determined voltage pattern is a decrease pattern.

For example, in the embodiment of FIG. 2, the control unit 130 may determine a first peak p1, a second peak p2, a third peak p3, a fourth peak p4, and a fifth peak p5 in the differential profile DP.

The electrode peak determining step (S300) is a step of determining a negative electrode peak and a positive electrode peak among the determined plurality of peaks, and may be performed by the control unit 130.

Here, the negative electrode peak is a peak that best represents the state of the negative electrode of the battery, and the positive electrode peak is a peak that best represents the state of the positive electrode of the battery. For example, in the embodiment of FIG. 2, among the first peak p1, the second peak p2, the third peak p3, the fourth peak p4, and the fifth peak p5, the first peak p1 may be determined as the negative electrode peak, and the fifth peak p5 may be determined as the positive electrode peak.

The state diagnosing step (S400) is a step for diagnosing the state of the battery by comparing the change rate of the negative electrode peak with respect to a preset reference negative electrode peak and the change rate of the positive electrode peak with respect to a preset reference positive electrode peak, and may be performed by the control unit 130.

Specifically, the control unit 130 may calculate a ratio of the differential capacity of the negative electrode peak to the preset reference negative electrode differential capacity, thereby calculating a differential capacity change rate of the negative electrode peak. In addition, the control unit 130 may calculate a ratio of the differential capacity of the positive electrode peak to the preset reference positive electrode differential capacity, thereby calculating a differential capacity change rate of the positive electrode peak.

The control unit 130 may be configured to diagnose the state of the battery as a positive and negative electrode deterioration state if the differential capacity change rate of the negative electrode peak exceeds the differential capacity change rate of the positive electrode peak. Conversely, the control unit 130 may be configured to diagnose the state of the battery as a positive electrode deterioration state if the differential capacity change rate of the negative electrode peak is less than or equal to the differential capacity change rate of the positive electrode peak.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measurement unit
100: battery management apparatus
110: profile obtaining unit
120: voltage obtaining unit
130: control unit
140: storage unit
600: vehicle
610: battery pack

## Claims

1. A battery management apparatus comprising:
a profile obtaining unit configured to obtain a differential profile representing a corresponding relationship between a differential capacity and a voltage of a battery;
a voltage obtaining unit configured to obtain an open circuit voltage of the battery; and
a control unit configured to determine a voltage pattern of the battery based on the open circuit voltage and pre-stored voltage history, determine a plurality of peaks in the differential profile when the determined voltage pattern is a predetermined pattern, determine a negative electrode peak and a positive electrode peak among the determined plurality of peaks, and diagnose a state of the battery by comparing a change rate of the negative electrode peak with respect to a preset reference negative electrode peak and a change rate of the positive electrode peak with respect to a preset reference positive electrode peak.

2. The battery management apparatus according to claim 1,
wherein the control unit is configured to calculate a differential capacity change rate of the negative electrode peak, calculate a differential capacity change rate of the positive electrode peak, compare the differential capacity change rate of the negative electrode peak and the differential capacity change rate of the positive electrode peak, and diagnose the state of the battery based on the comparison result.

3. The battery management apparatus according to claim 2,
wherein the control unit is configured to calculate the differential capacity change rate of the negative electrode peak by calculating a ratio of the differential capacity of the negative electrode peak to a preset reference negative electrode differential capacity, and calculate the differential capacity change rate of the positive electrode peak by calculating a ratio of the differential capacity of the positive electrode peak to a preset reference positive electrode differential capacity.

4. The battery management apparatus according to claim 2,
wherein the control unit is configured to diagnose the state of the battery as a positive and negative electrode deterioration state when the differential capacity change rate of the negative electrode peak exceeds the differential capacity change rate of the positive electrode peak, and
wherein the control unit is configured to diagnose the state of the battery as a positive electrode deterioration state when the differential capacity change rate of the negative electrode peak is less than or equal to the differential capacity change rate of the positive electrode peak.

5. The battery management apparatus according to claim 4,
wherein the control unit is configured to adjust a use condition preset for the battery based on the diagnosed state of the battery.

6. The battery management apparatus according to claim 1,
wherein the control unit is configured to calculate a voltage change rate based on the open circuit voltage and the pre-stored voltage history, and compare the calculated voltage change rate with a preset reference change rate to determine the voltage pattern of the battery as a decrease pattern or a non-decrease pattern.

7. The battery management apparatus according to claim 6,
wherein the control unit is configured to determine the plurality of peaks in the differential profile when the determined voltage pattern is the decrease pattern.

8. The battery management apparatus according to claim 1,
wherein the voltage obtaining unit is configured to obtain an open circuit voltage after charging of the battery is terminated, and
wherein the profile obtaining unit is configured to obtain a differential profile representing a corresponding relationship between the differential capacity and the voltage of the battery during a charging process.

9. A battery pack comprising the battery management apparatus according to any one of claims 1 to 8.

10. A vehicle comprising the battery management apparatus according to any one of claims 1 to 8.

11. A battery management method comprising:
a voltage pattern determining step of determining a voltage pattern of a battery based on an open circuit voltage of the battery and pre-stored voltage history;
a peak determining step of determining a plurality of peaks in a differential profile representing a corresponding relationship between a differential capacity and a voltage of the battery when the determined voltage pattern is a predetermined pattern;
an electrode peak determining step of determining a negative electrode peak and a positive electrode peak among the determined plurality of peaks; and
a state diagnosing step of diagnosing a state of the battery by comparing a change rate of the negative electrode peak with respect to a preset reference negative electrode peak and a change rate of the positive electrode peak with respect to a preset reference positive electrode peak.
